# EUROPEAN PATENT APPLICATION

(11) **EP 4 002 219 A1**
(43) Date of publication of application: **25.05.2022**
(21) Application number: 20306365.6
(22) Date of filing: 12.11.2020
(51) Int. Cl.: G06N 3/063, G06N 3/04, G06N 3/08

(54) **CIRCUIT AND METHOD FOR SPIKE TIME DEPENDENT PLASTICITY**

(71) Applicant: Commissariat à l'Energie Atomique et aux Energies Alternatives, 75015 Paris (FR); Universität Zürich, 8006 Zürich (CH)
(72) Inventor: DALGATY, Thomas, 38054 Grenoble cedex 09 (FR); VIANELLO, Elisa, 38054 Grenoble cedex 09 (FR); MORO, Filippo, 38054 Grenoble cedex 09 (FR); INDIVERI, Giacomo, 8057 Zurich (CH); PAYVAND, Melika, 8057 Zurich (CH)
(74) Representative: Cabinet Beaumont

(57) **Abstract**

The present disclosure relates to a neuron circuit of a spiking neural network comprising: a first resistive switching memory device (902, 904) having a conductance that decays over time; and a programming circuit configured to reset the resistive state of the first resistive switching element in response to a spike in an output voltage of the neuron circuit.

## Description

### Technical field

The present disclosure relates generally to the field of neural networks, and in particular to a synapse circuit of a spiking neural network.

### Background art

Spiking neural networks are computing architectures that are developed to mimic, to a certain extent, neuro-biological systems. Such neural networks generally comprise a network of artificial neurons, which are electrical circuits that receive inputs, combine these inputs with their internal state and often with a threshold, and produce an output signal. Outputs of neurons are coupled to the inputs of other neurons by connections, which are referred to as synapses, their equivalent in the biological brain.

In a neural network, signals, sometimes in the form of spikes, produced by source neurons are transmitted to one or more synapse circuits, which perform one or more transformations on the signal before they are integrated, possibly with different gain factors, and conveyed to one or more post-synaptic neurons. The function used to generate the input to a post-synaptic neuron, based on the outputs of its predecessor neurons and the connections as a weighted sum, is known as the propagation function. The weight applied by each synapse circuit is often referred to as the synapse weight.

The predominant neuroscience-inspired learning algorithm, often called a learning rule, is the so-called Spike-Time-Dependent-Plasticity (STDP) approach. According to STDP, the difference in the spike timing between pairs of neurons influences the strength and sign of the synapse weight applied between them. Thus, the learning rule is the modification of the synapse weights as a function of the spike timing differences between pre- and post-synaptic neurons.

There is however a technical difficulty in providing a compact and low-cost implementation allowing such a learning rule to be applied.

### Summary of Invention

It is an aim of embodiments of the present disclosure to at least partially address one or more needs in the prior art.

According to one embodiment, there is provided a neuron circuit of a spiking neural network comprising: a first resistive switching memory device having a conductance that decays over time; and a programming circuit configured to reset the resistive state of the first resistive switching element in response to a spike in an output voltage of the neuron circuit.

According to one embodiment, the first resistive switching memory device is a phase change memory device or a conductive-bridging random-access memory device.

According to one embodiment, the neuron circuit is a pre-synaptic neuron circuit.

According to a further aspect, there is provided a spiking neural network comprising: the above neuron circuit; and a synapse circuit coupling the neuron circuit to a post synaptic neuron circuit, wherein the synapse circuit comprises a further resistive memory device configured to store a synaptic weight, wherein the programming circuit, or a further programming circuit, is configured to update the synaptic weight based on a conductance value of the first resistive switching memory device.

According to one embodiment, the spiking neural network further comprising a control circuit configured to read the conductance value of the first resistive switching memory device, to compare the conductance value with a first threshold, and to update the synaptic weight by increasing the conductance of the further resistive memory device if the conductance value exceeds the first threshold.

According to one embodiment, in the case that the conductance value does not exceed the first threshold, the control circuit is further configured to compare the conductance value with a second threshold, and to update the synaptic weight by decreasing the conductance of the further resistive memory device if the conductance value exceeds the second threshold.

According to one embodiment, the post-synaptic neuron circuit comprises: a second resistive switching memory device having a conductance that decays over time, and the programming circuit, or another programming circuit, is configured to reset the resistive state of the second resistive switching element in response to a spike in an output voltage of the post-synaptic neuron circuit.

According to one embodiment, the control circuit is further configured to read the conductance value of the second resistive switching memory device, to compare the conductance value of the second resistive switching memory device with a third threshold, and to update the synaptic weight by decreasing the conductance of the further resistive memory device if the conductance value exceeds the third threshold.

According to a further aspect, there is provided a method storing a duration between pre- and post-synaptic neuron spikes in a spiking neural network, the method comprising resetting, by a programming circuit, the resistive state of a first resistive switching element of a neuron circuit in response to a spike in an output voltage of the neuron circuit.

According to yet a further aspect, there is provided a learning method for a spiking neural network, the method comprising: storing the duration between pre- and post-synaptic neuron spikes according to the above method; and storing, by the programming circuit or by another programming circuit, a synaptic weight to a further resistive memory device of a synapse circuit coupling the neuron circuit to a post synaptic neuron circuit; and updating the synaptic weight based on a conductance value of the first resistive switching memory device.

According to one embodiment, the method further comprises: reading, by a control circuit, the conductance value of the first resistive switching memory device; comparing the conductance value with a first threshold; and updating the synaptic weight by increasing the conductance of the further resistive memory device if the conductance value exceeds the first threshold.

According to one embodiment, the method further comprises, in the case that the conductance value does not exceed the first threshold: comparing the conductance value with a second threshold; and updating the synaptic weight by decreasing the conductance of the further resistive memory device if the conductance value exceeds the second threshold.

According to one embodiment, the method further comprises: resetting the resistive state of a second resistive switching memory device of the post-synaptic neuron circuit in response to a spike in an output voltage of the post-synaptic neuron circuit, wherein the second resistive switching memory device has a conductance that decays over time.

According to one embodiment, the method further comprises: reading, by the control circuit , the conductance value of the second resistive switching memory device; comparing the conductance value of the second resistive switching memory device with a third threshold; and updating the synaptic weight by decreasing the conductance of the further resistive memory device if the conductance value exceeds the third threshold.

### Brief description of drawings

The foregoing features and advantages, as well as others, will be described in detail in the following description of specific embodiments given by way of illustration and not limitation with reference to the accompanying drawings, in which:
Figure 1 schematically illustrates part of a spiking neural network comprising PRE neurons and POST neurons coupled together by synapses;
Figure 2 schematically illustrates experimentally observed spike-timing-dependent-plasticity between neurons;
Figure 3 is a graph representing a change in excitatory postsynaptic potential (EPSP) as a function of spike timing;
Figure 4 schematically illustrates a neural network comprising an array of synapse circuits according to an example embodiment;
Figure 5 illustrates a resistive memory device according to an example embodiment;
Figure 6 is a timing diagram illustrating an example of pre-synaptic and post-synaptic spikes;
Figure 7A illustrates an example of a pre-before post-synaptic spike;
Figure 7B illustrates an example of post-before pre-synaptic spike;
Figure 7C is a graph illustrating an example of a synaptic weight applied based on relative timing of pre-synaptic and post-synaptic spikes;
Figure 8 is a graph illustrating an example of conductance drift of a phase change memory (PCM) device over time;
Figure 9 schematically illustrates a neural network comprising an array of synapse circuits according to an example embodiment of the present disclosure;
Figure 10 is a graph illustrating an example of applied modulation of a synaptic weight as a function of relative timing of pre-synaptic and post-synaptic spikes according to an example embodiment of the present disclosure;
Figure 11 is a timing diagram illustrating an example of variations in the conductance of resistive memory devices as a function of relative timing of pre-synaptic and post-synaptic spikes according to an example embodiment of the present disclosure;
Figure 12 is a flow diagram illustrating operations in a method of generating a synapse weight according to an example embodiment of the present disclosure;
Figure 13 schematically illustrates an example of a circuit implementing the method of Figure 12 according to an example embodiment of the present disclosure;
Figure 14 schematically illustrates a neural circuit comprising an array of synapse circuits according to a further example embodiment of the present disclosure;
Figure 15 is a graph illustrating an example of applied modulation of a synaptic weight as a function of relative timing of pre-synaptic and post-synaptic spikes according to a further example embodiment of the present disclosure;
Figure 16 is a timing diagram illustrating an example of variations in the conductance of resistive memory devices as a function of relative timing of pre-synaptic and post-synaptic spikes according to a further example embodiment of the present disclosure;
Figure 17 is a flow diagram illustrating operations in a method of generating a synapse weight according to an example embodiment of the present disclosure; and
Figure 18 is a cross-section view illustrating a transistor layer and metal stack forming part of a spiking neural network according to an example embodiment of the present disclosure.

### Description of embodiments

Like features have been designated by like references in the various figures. In particular, the structural and/or functional features that are common among the various embodiments may have the same references and may dispose identical structural, dimensional and material properties.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 %, and preferably within 5 %.

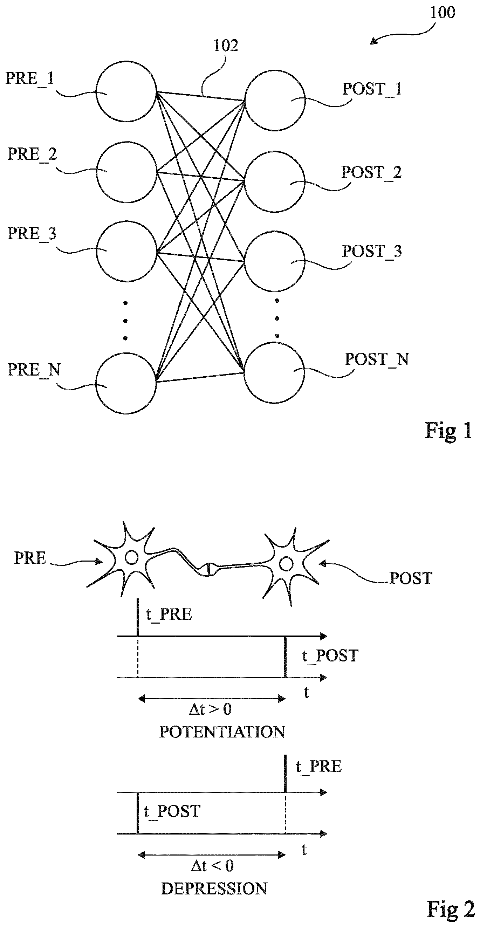

Figure 1 schematically illustrates part of an spiking neural network 100 comprising PRE neurons PRE_1 to PRE_N and POST neurons POST_1 to POST_N coupled together by synapses 102, where N is for example equal to at least 2, and typically tens or hundreds. In the example of Figure 1, there are an equal number N of PRE neurons and POST neurons, but in some applications, the number could vary. The PRE neurons and POST neurons of Figure 1 for example represent successive layers of a spiking neural network, which could be a classifying network, or other type of network. While Figure 1 illustrates an example of a fully-connected network in which a synapse 102 connects each PRE neuron to each POST neuron, in alternative embodiments there could be less connections.

Each of the synapses 102 is for example implemented by a synapse circuit that receives a membrane voltage of the corresponding PRE neuron, applies a transfer function to this output based on a weight, and supplies an output excitation to the corresponding POST neuron.

A neural network comprising the PRE neurons and POST neurons of Figure 1 for example operates in two different phases. In a learning phase, the weights applied by each synapse are for example learnt. For example, the learning is based on training data. In a functional phase, the neural network operates on real data in order to perform data analysis functions, such as classification, auto-association, etc. Alternatively, the neural network may operate according to an unsupervised continuous learning approach, in which case no training data is used, and the learning phase is thus avoided. Instead, learning continues over the lifetime of the network.

Figure 2 schematically illustrates experimentally observed spike-timing-dependent-plasticity between a PRE neuron (PRE) and a post neuron (POST).

As represented by timing diagrams in Figure 2, in the case that a pre-synaptic spike occurs at a time t_PRE before a post-synaptic spike at a time t_POST, the time different Δ*t* between the spikes is designated as positive. As such, a long-term potentiation (LTP) is for example applied to the synapse weight, as indicated by the word POTENTIATION.

In the case that a post-synaptic spike occurs at a time t_POST before a pre-synaptic spike at a time t_PRE, the time different Δ*t* between the spikes is designated as negative. As such, a long-term depression (LTD) is for example applied to the synapse weight, as indicated by the word DEPRESSION.

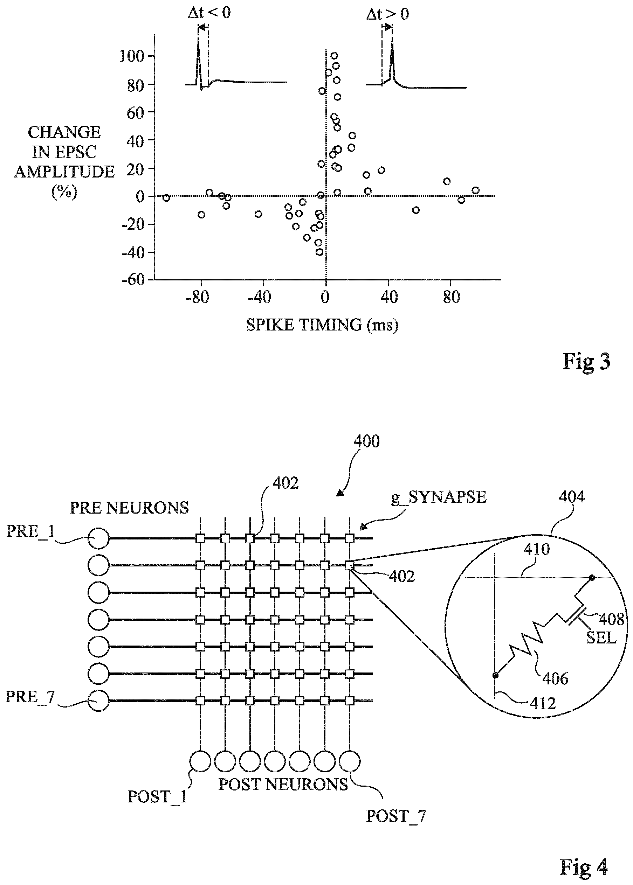

Indeed, Figure 3 demonstrates such a relation in the case of experimentally observed STDP between neurons, as will now be described.

Figure 3 is a graph representing a change in excitatory post-synaptic potential (EPSP) as a function of spike timing. It can be seen that the EPSC amplitude is based on a 1/Δ*t* relation.

Figure 4 schematically illustrates a neural network comprising an array 400 of synapse circuits 402 according to an example embodiment of the present disclosure. In the example of Figure 4, the array 400 couples seven PRE neurons PRE_1 to PRE_7 to seven POST neurons POST_1 to POST_7, and thus there are 49 synapse circuit 402 arranged in seven columns and seven rows. However, in alternative embodiments, there could be any number of PRE and POST neurons and the array 402 could be of a corresponding size. For example, there are at least two PRE neurons and at least two POST neurons.

Each of the synapse circuit 402 of the array for example comprises a non-volatile memory device storing a synapse weight g_SYNAPSE associated with the synapse circuit. The memory device is for example implemented by a PCM device, or other type of resistive random-access memory (ReRAM) device, such as an oxide RAM (OxRAM) device, which is based on so-called "filamentary switching". The memory devices of the array are for example coupled at each intersection between a PRE neuron and a POST neuron in a cross-bar fashion, as known by those skilled in the art. For example, a blow-up view 414 in Figure 4 illustrates an example of this intersection, a resistive memory device 406 being coupled in series with a transistor 408 between a line 410 coupled to a corresponding PRE neuron, and a line 412 coupled to a corresponding POST neuron. The transistor 408 is for example controlled by a selection signal SEL generated by a control circuit (not illustrated in Figure 4).

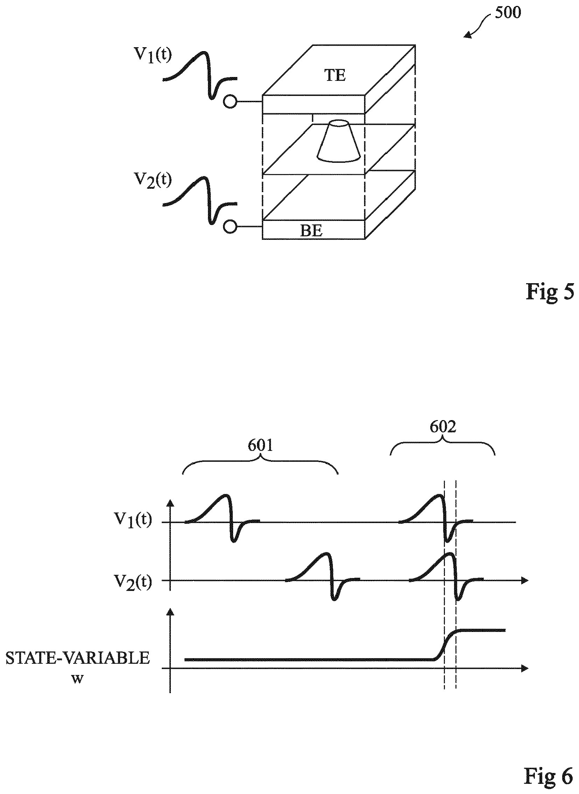

Figure 5 illustrates a filamentary memory device 500, such as an OxRAM (Oxide RAM) device or a CBRAM (Conductive Bridging RAM) device, according to an example embodiment comprising a top electrode (TE) and a bottom electrode (BE). Figure 5 illustrates an example in which the device 500 is programmed according to the relative timing of pre- and post-synaptic neuron spikes. For example, a voltage signal *V*₁(*t*) is applied to the top electrode, this voltage signal corresponding to the output voltage of the pre neuron, and thus providing the pre-synaptic neuron spikes. A voltage signal *V*₂(*t*) is applied to the bottom electrode, this voltage signal corresponding to the output voltage of the post neuron, and thus providing the post-synaptic neuron spikes.

The device 500 is thus exposed to a difference between the action potentials generated by the pre and post neurons, as represented in Figure 6.

Figure 6 is a timing diagram illustrating an example of the voltage signals *V*₁(*t*) and *V*₂(*t*) of Figure 5, and of a first state variable w, corresponding to the conductance to be programmed.

In a first example 601 of Figure 6, the pre- and post-synaptic spikes are relatively far from one another, and thus there is no time overlap between the spikes. In this case, the conductance w is not modified.

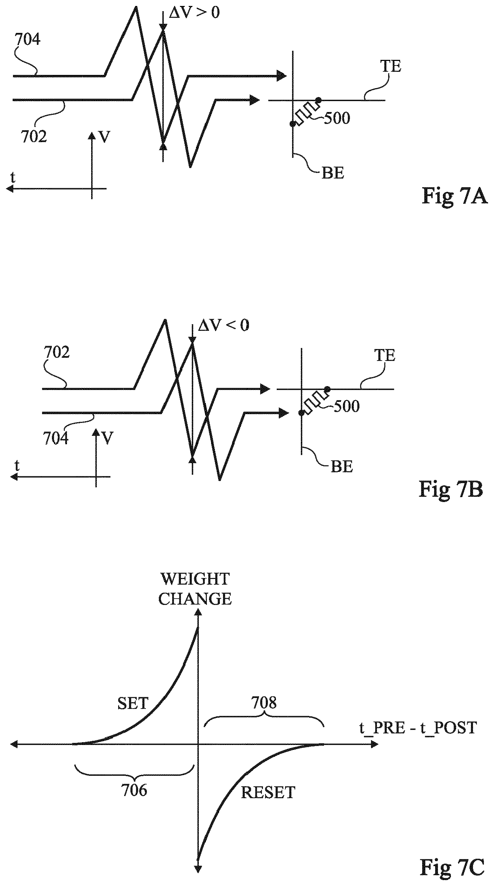

In a second example 602 of Figure 6, the pre- and post-synaptic spikes are partially overlapping, resulting in a voltage difference applied across the device, leading to a increase in the conductance w. This will now be described in more detail with reference to Figures 7A to 7C.

Figure 7A illustrates an example of a pre-before post-synaptic spike.

In particular, Figure 7A illustrates a pre-synaptic spike 702 arriving at the top electrode TE of the resistive memory device 500 before a post-synaptic spike 704, leading to a positive voltage difference Δ*V* across the device.

Figure 7B illustrates another example in which the pre-synaptic spike 702 arrives at the top electrode TE of the resistive memory device 500 after the post-synaptic spike 704, leading to a negative voltage difference Δ*V* across the device.

Figure 7C is a graph illustrating an example of a synaptic weight change applied based on relative timing of pre-synaptic and post-synaptic spikes. In particular, the x-axis represents the time difference t_PRE-t_POST, where t_PRE is the time of the pre-synaptic neuron spike, and t_POST is the time of the post-synaptic neuron spike. As represented by a range 706, when this time different is negative, i.e. the pre-synaptic spike occurs before the post-synaptic spike, the voltage difference Δ*V* across the device leads to a SET operation. As represented by a range 708, when this time different is positive, i.e. the pre-synaptic spike occurs after the post-synaptic spike, the voltage difference Δ*V* across the device leads to a RESET operation.

Thus, as represented in Figures 5 to 7, by properly designing the shapes of the action potential, i.e. output spikes, of the pre- and post-synaptic neurons, the resulting voltage peak can be proportional to the time difference between spikes. However, the hardware implementation of such an algorithm presents certain challenges. Firstly, this approach could only work with bipolar devices such as OxRAM or CBRAM, implying that the set and reset voltages have opposite polarities. Furthermore, the action potentials are distributed over the whole line or column of synaptic circuits, thus producing read disturb. Indeed, the programming of the device should only occur when there is pulse overlap, but in practice the resistance value will be disturbed each time that the device sees a pulse. Furthermore, the shape of the action potential is crucial for a correct implementation of the algorithm, thus involving a complex analog programming. Furthermore, neuromorphic systems operate at time constants of the order of milliseconds. As a consequence, relatively long action potentials should be generated to account for high spike time-differences. This results in power consumption issues for such implementations.

An alternative approach for updating synapse weights will now be described, based on a conductance drift phenomenon. In particular, the post-programming conductance drift of phase change memory (PCM) resistive RAM devices is used to store information concerning the time that has passed since a most recent pre- or post-synaptic neuron spike event. A PCM device is a unipolar device, meaning that the set and reset voltages have the same polarity.

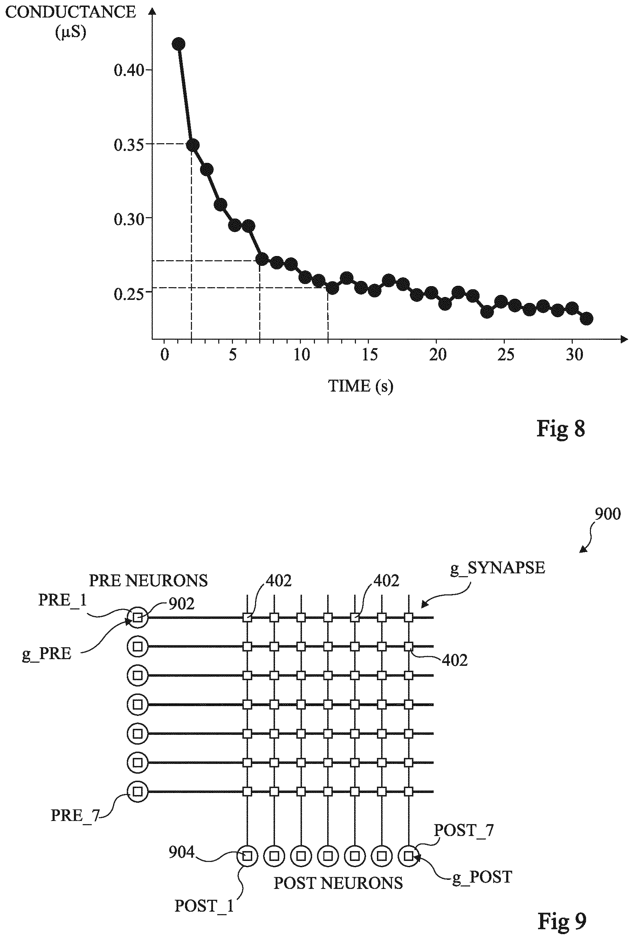

Figure 8 is a graph illustrating an example of conductance drift of a phase change memory device over time. In particular, for a PCM device that has its resistance state reset to a high resistive state (HRS) at a time t0 and is left drifting for 30 seconds, it can be observed that the conductivity presents a power law decay, the time-constant of which depends on the reset conditions. In the example embodiment, the conductance is at around 0.35 µS after 2 s, and has fallen to around 0.27 µS after 7 s, and to around 0.255 µS after 12 s. Thus, the conductance drift substantially follows a relation of 1/t.

The phase-change memory devices are for example chalcogenide-based devices, in which the resistive switching layer is formed of polycrystalline chalcogenide, placed in contact with a heater.

As known by those skilled in the art, a reset operation of a PCM device involves applying a relatively high current through the device for a relatively short duration. For example, the duration of the current pulse is of less than 10 ns. This causes a melting of a region of a resistive switching layer of the device, which then changes from a crystalline phase to an amorphous phase, and then cools without recrystallizing. This amorphous phase has a relatively high electrical resistance. Furthermore, this resistance increases with time following the reset operation, corresponding to a decrease in the conductance of the device. Such a drift is for example particularly apparent when the device is reset using a relatively high current, leading to a relatively high initial resistance, and a higher subsequent drift. Those skilled in the art will understand how to measure the drift that occurs based on different reset states, i.e. different programming currents, and will then be capable of choosing a suitable programming current that results in an amount of drift that can be exploited as described herein.

As also known by those skilled in the art, a set operation of a PCM device involves applying a current that is lower than the current applied during the reset operation, for a longer duration. For example, the duration of the current pulse is of more than 100 ns. This for example causes the amorphous region of the resistive switching layer of the device to change from the amorphous phase back to the crystalline phase as the current reduces. The resistance of the device is thus relatively low.

Figure 9 schematically illustrates a neural network comprising an array 900 of synapse circuits 402 according to an example embodiment of the present disclosure. The circuit of Figure 9 for example corresponds to a two-layer neural network. Alternatively, there could be one or more additional layers that are not illustrated. The array 900 is similar to the example of Figure 4, except that the pre and post neurons (PRE NEURONS, POST NEURONS) comprise resistive memory devices, as will now be described in more detail.

One or more of the pre-synaptic neurons for example stores a time indication represented by the conductance g_PRE of a resistive switching memory device 902, and/or one or more of the post-synaptic neurons for example stores a time indication represented by the conductance g_POST of a resistive switching memory device 904. In the example of Figure 9, each of the pre-synaptic neurons PRE_1 to PRE_7 and each of the post-synaptic neurons POST_1 to POST_7 comprises such a resistive memory device 902 or 904. The resistive memory devices 902, 904 are for example PCM devices programmed in a low conductance state, this conductance for example being relatively low for the devices to exhibit drift, and thus a decay in their conductance over time, as explained above. Other resistive memory technologies that also exhibit a similar decay, and thus could be used as an alternative, include Ag/SiOx conductive-bridging RAM (CBRAM) devices or other RRAM devices that have relatively poor data retention, and which thus store data in a volatile fashion.

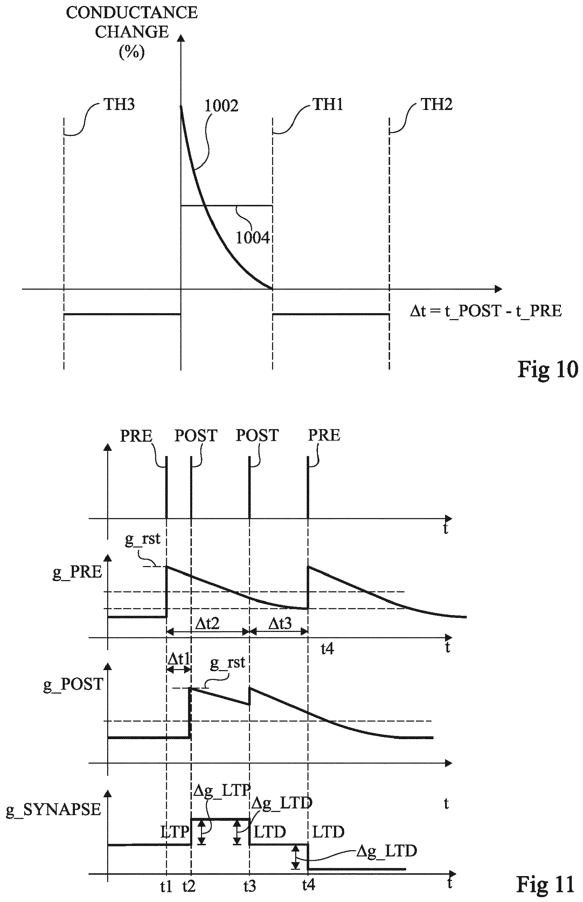

The conductance of the resistive memory device 902, 904 of the pre- and post-synaptic neurons can be used to determine a time difference between pre- and post-synaptic spikes, as will now be described in more detail with reference to Figures 10 and 11.

Figure 10 is a graph illustrating an example of applied modulation of a synaptic weight as a function of relative timing of pre-synaptic and post-synaptic spikes according to an example embodiment of the present disclosure. In particular, Figure 10 illustrates the conductance change (CONDUCTANCE CHANGE) as a percentage. In particular, the synapse for example has bounded values, and the percentage indicated by the y-axis of Figure 10 corresponds to the percentage change as referred to the previous conductance value..

As illustrated, according to the example of Figure 10, when Δ*t* is positive, in other words t_POST is after t_PRE, and Δ*t* is below a threshold time TH1, the conductance g_SYNAPSE representing the synaptic weight is for example increased by between zero and 100 percent as a function of the value of Δ*t*. Alternatively, as shown by a line 1004 in Figure 10 the conductance g_SYNAPSE representing the synaptic weight is for example increased by a fixed percentage, this percentage for example being in the range 10 % to 50 %, although this will depend on the application.

When Δ*t* is positive, above the threshold TH1 and below a further threshold TH2, or when Δ*t* is negative and above a threshold TH3, the conductance g_SYNAPSE representing the synaptic weight is for example decreased by a fixed percentage, this percentage for example being in the range 5 % to 30 %, although, again, this will depend on the application.

When Δ*t* is below the threshold TH3 or above the threshold TH2, the conductance g_SYNAPSE is for example not changed.

Figure 11 is a timing diagram illustrating an example of variations in the conductance of resistive memory devices as a function of relative timing of pre-synaptic and post-synaptic spikes according to an example embodiment of the present disclosure. In particular, Figure 11 illustrates examples of the timing of pre-synaptic neuron spikes PRE and of post-synaptic neuron spikes POST, and of the conductance g_PRE, g_POST and g_SYNAPSE of the corresponding resistive memory devices.

Initially, it is assumed that the conductance g_PRE, g_POST and g_SYNAPSE are each at a corresponding initial state of conductance, wherein these states may be different from each other.

At a time t1, a pre-synaptic spike occurs, and in response, the conductance g_PRE is for example reset, bringing it to a level g_rst. This conductance then starts to decay. It is assumed that the time delay Δ*t* since the last post-synaptic spike (not illustrated) was less than the threshold TH3, and thus no change to the conductance g_SYNAPSE is for example applied.

At a time t2, a post-synaptic spike occurs, and in response, the conductance g_POST is for example reset, bringing it to a level g_rst. This conductance then starts to decay. Furthermore, the time difference Δ*t*1 since the last pre-synaptic spike is positive, and is compared to the threshold TH1. As it is below the threshold, the conductance g_SYNAPSE is for example increased by a long-term potentiation LTP, which in this example is a fixed increase of Δ*g_LTP.*

At a time t3, another post-synaptic spike occurs, and in response, the conductance g_POST is for example again reset, bringing it back to the level g_rst. This conductance then starts to decay. Furthermore, the time difference Δ*t*2 since the last pre-synaptic spike is positive, and is compared to the threshold TH1. In this example, it is for example greater than the threshold TH1, and so it is compared to the threshold TH2. As it is below the threshold TH2, the conductance g_SYNAPSE is for example decreased by a long-term depression LTD, which in this example is a fixed decrease of Δ*g_LTD.*

At a time t4, a pre-synaptic spike occurs, and in response, the conductance g_PRE is for example again reset, bringing it back to the level g_rst. This conductance then starts to decay. Furthermore, the time difference Δ*t*3, equal to the time t_POST of the last post-synaptic spike minus the time t_PRE of the current pre-synaptic spike, is negative. Therefore, it is compared to the threshold TH3, and found to be above this threshold, i.e. less negative than the thresold. Therefore, the conductance g_SYNAPSE is for example decreased by a long-term depression LTD, which in this example is a fixed decrease of Δ*g_LTD.*

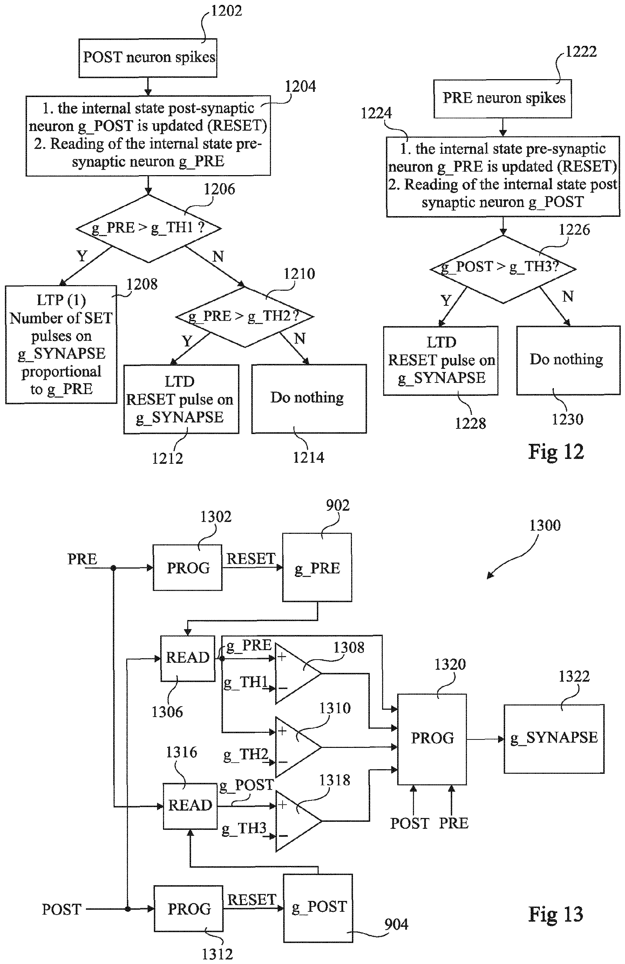

Figure 12 is a flow diagram illustrating operations in a method of generating a synapse weight according to an example embodiment of the present disclosure.

A flow on the left in Figure 12 represents the case of a POST neuron spike, as shown by an event 1202. In this case, in an operation 1204, the conductance g_POST is updated by resetting the corresponding resistive memory device 904. Furthermore, a current conductance of the internal state of the pre-synaptic neuron g_PRE is read. Then, in operation 1206, it is determined whether the current conductance g_PRE of the resistive memory device 902 associated with the pre-synaptic neuron has a conductance greater than g_TH1, where g_TH1 is a conductance associated with the time threshold TH1 described above. In particular, g_TH1 is conductance that g_PRE will fall to from the initial level g_rst after the time interval of TH1. If g_PRE is over the threshold g_TH1 (branch Y), this implies that Δ*t* is less than the time threshold TH1. Therefore, in an operation 1208, the conductance g_SYNAPSE is updated by an LTP. For example, this could be by a fixed amount as described in relation with Figure 11, or by applying a number of SET pulses to the device proportional to the value of g_PRE. Alternatively, if in operation 1206 it is found that the conductance g_PRE is not greater than the threshold g_TH1 (branch N), in an operation 1210, it is determined whether the current conductance g_PRE of the resistive memory device 902 associated with the pre-synaptic neuron has a conductance greater than g_TH2, where g_TH2 is a conductance associated with the time threshold TH2 described above. If so (branch Y), in an operation 1212, the conductance g_SYNAPSE is updated by an LTD, which is for example a decrease of a fixed amount. If not (branch N), nothing is done (block 1214).

A flow on the right in Figure 12 represents the case of a PRE neuron spike, as shown by an event 1222. In this case, in an operation 1224, the conductance g_PRE is updated by resetting the corresponding resistive memory device 902. Furthermore, a current conductance of the internal state of the post-synaptic neuron g_POST is read. Then, in operation 1226, it is determined whether the current conductance g_POST of the resistive memory device 904 associated with the post-synaptic neuron has a conductance greater than g_TH3, where g_TH3 is a conductance associated with the time threshold TH3 described above. In particular, g_TH3 is conductance that g_POST will fall to from the initial level g_rst after the time interval of TH3. If g_POST is over the threshold g_TH3 (branch Y), this implies that Δ*t* is greater (less negative) than the time threshold TH3. Therefore, in an operation 1208, the conductance g_SYNAPSE is updated by an LTD. For example, this is by a fixed amount as described in relation with Figure 11. Alternatively, if in operation 1226 it is found that the conductance g_POST is not greater than the threshold g_TH3 (branch N), nothing is done (block 1230).

Figure 13 schematically illustrates an example of a circuit 1300 implementing the method of Figure 12 according to an example embodiment of the present disclosure.

The circuit 1300 for example comprises a programming circuit (PROG) 1302, which receives the signal PRE from the pre-synaptic neuron, and in response to a pre-synaptic spike of this signal, it for example resets the conductance g_PRE of the resistive memory device 902 of the pre-synaptic neuron.

A read circuit (READ) 1306 is also configured to read a conductance of the device 902 in response to a post-synaptic spike of the signal POST from the post-synaptic neuron. The read circuit 1306 for example provides the read value g_PRE to an input of a comparator 1308, which is configured to compare the value g_PRE with the threshold g_TH1. The output of the comparator 1308 is coupled to a programming circuit (PROG) 1320. The read circuit 1306 also for example provides the read value g_PRE to an input of a comparator 1310, which is configured to compare the value g_PRE with the threshold g_TH2. The output of the comparator 1310 is also coupled to the programming circuit (PROG) 1320.

Similarly, the circuit 1300 for example comprises a programming circuit (PROG) 1312, which receives the signal POST from the post-synaptic neuron, and in response to a post-synaptic spike of this signal, it for example resets the conductance g_POST of the resistive memory device 904 of the post-synaptic neuron.

A read circuit (READ) 1316 is also configured to read a conductance of the device 904 in response to a pre-synaptic spike of the signal PRE from the pre-synaptic neuron. The read circuit 1316 for example provides the read value g_POST to an input of a comparator 1318, which is configured to compare the value g_POST with the threshold g_TH3. The output of the comparator 1318 is coupled to the programming circuit (PROG) 1320.

The programming circuit 1320 also for example receives the read conductance value g_PRE and the signals POST and PRE. The programming circuit 1320 is for example configured to apply the operations 1206 to 1214 and 1226 to 1230 of Figure 12 in response to each pre- and post-synaptic neuron spike, in order to program the conductance g_SYNAPSE of the resistive memory device 1322 of the synapse circuit.

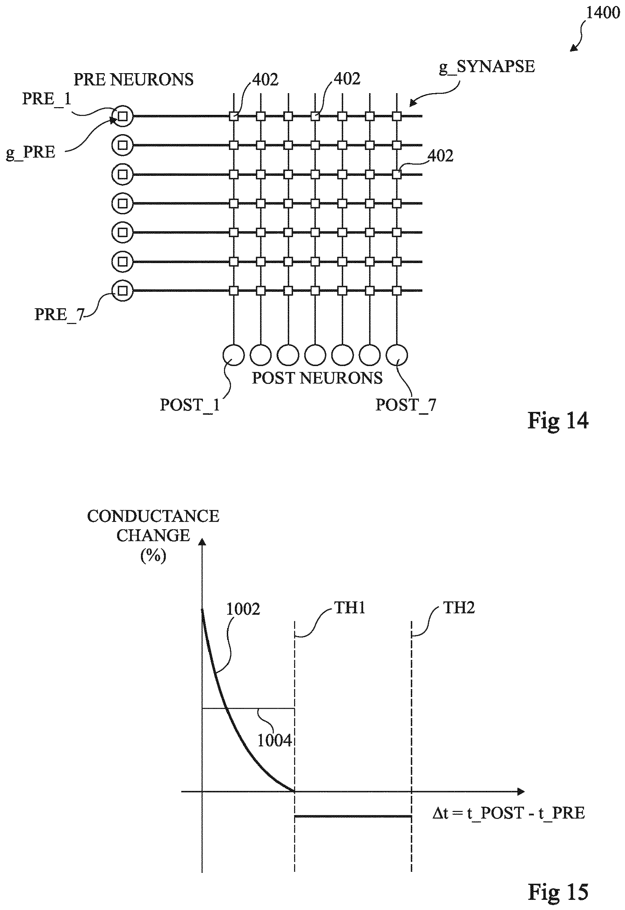

While in the embodiment of Figures 9 to 13 both the pre-synaptic neurons and post-synaptic neurons comprise resistive memory devices 902, 904 for storing corresponding conductance levels, in an alternative embodiment, only the pre-synaptic neurons comprise such resistive memory devices, as will now be described in more detail with reference to Figures 14 to 17.

Figure 14 schematically illustrates a neural network comprising an array 1400 of synapse circuits 402 according to a further example embodiment of the present disclosure. Like for Figure 9, the circuit of Figure 14 for example corresponds to a two-layer neural network. Alternatively, there could be one or more additional layers that are not illustrated. The array 1400 is similar to the one of Figure 9, except that the post-synaptic neurons PST_1 to POST_7 do not comprise resistive memory devices 904.

Figure 15 is a graph illustrating an example of applied modulation of a synaptic weight as a function of relative timing of pre-synaptic and post-synaptic spikes according to a further example embodiment of the present disclosure. The graph of Figure 15 is the same as the graph of Figure 10, except that a negative value of Δ*t* is not considered.

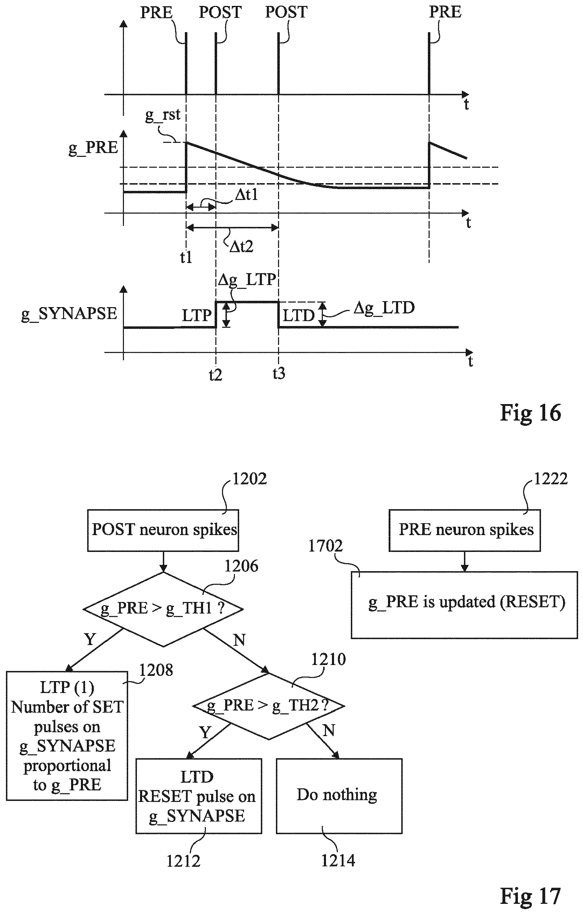

Figure 16 is a timing diagram illustrating an example of variations in the conductance of resistive memory devices as a function of relative timing of pre-synaptic and post-synaptic spikes according to a further example embodiment of the present disclosure. In particular, Figure 16 illustrates example of the timing of pre-synaptic neuron spikes PRE and of post-synaptic neuron spikes POST, and of the conductance g_PRE and g_SYNAPSE of the corresponding resistive memory devices.

Initially, it is assumed that the conductance g_PRE and g_SYNAPSE are at substantially the same level, which is at around 30 percent of their initial reset state conductance, although any initial states would be possible.

At a time t1, a pre-synaptic spike occurs, and in response, the conductance g_PRE is for example reset, bringing it to a level g_rst. This conductance then starts to decay.

At a time t2, a post-synaptic spike occurs, and in response, the time difference Δ*t*1 since the last pre-synaptic spike is compared to the threshold TH1. As it is below the threshold, the conductance g_SYNAPSE is for example increased by a long-term potentiation LTP, which in this example is a fixed increase of Δ*g_LTP.*

At a time t3, another post-synaptic spike occurs, and in response, the time difference Δ*t*2 since the last pre-synaptic spike is compared to the threshold TH1. In this example, it is for example greater than the threshold TH1, and so it is compared to the threshold TH2. As it is below the threshold TH2, the conductance g_SYNAPSE is for example decreased by a long-term depression LTD, which in this example is a fixed decrease of Δ*g_LTD.*

At a time t4, a pre-synaptic spike occurs, and in response, the conductance g_PRE is for example again reset, bringing it back to the level g_rst.

Figure 17 is a flow diagram illustrating operations in a method of generating a synapse weight according to an example embodiment of the present disclosure. The flow diagram of Figure 17 is the same as the flow diagram of Figure 12, except that the operations 1224 to 1230 are replaced by an operation 1702 in which only the conductance g_PRE of the resistive memory device 902 associated with the pre-synaptic neuron is updated by a reset operation.

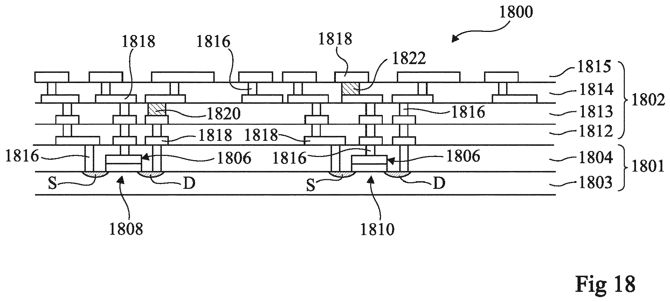

Figure 18 is a cross-section view illustrating a transistor layer 1801 and a metal stack 1802 forming a portion 1800 of a spiking neural network, and illustrates an example of the co-integration of two types of resistive memory devices. For example, such a structure is used to form the networks 900 and/or 1400 of Figures 9 and 14 in the case that the PRE neurons (and POST neurons in the case of Figure 9) are formed of PCM devices, while the synapse weight g_SYNAPSE associated with the synapse circuit is implemented by another type of resistive memory device, such as a filamentary switching device.

The transistor layer 1801 is formed of a top region 1803 of a silicon substrate in which transistor sources and drains S, D, are formed, and a transistor gate layer 1804 in which gate stacks 1806 of the transistors are formed. Two transistors 1808, 1810 are illustrated in the example of Figure 18.

The metal stack 1802 comprises four interconnection levels 1812, 1813, 1814 and 1815 in the example of Figure 18, each interconnection level for example comprising a patterned metal layer 1818 and metal vias 1816 coupling metal layers, surrounded by a dielectric material. Furthermore, metal vias 1816 for example extend from the source, drain and gate contacts of the transistors 1808, 1810 to the metal layer 1818 of the interconnection level 1812.

In the example of Figure 18, a restive memory device 1820 of a first type, such as of the PCM type, is formed in the interconnection level 1813, and for example extends between the metal layers 1818 of the interconnection levels 1813 and 1814. A resistive memory device 1822 of a second type, such as of the filamentary switching type, is formed in the interconnection level 1814, and for example extends between the metal layers 1818 of the interconnection levels 1814 and 1815.

An advantage of the embodiments described herein is that an evaluation of a spike time interval can be made in a simple, low-cost and compact fashion using the drift or decay property of a resistive switching memory device.

Various embodiments and variants have been described. Those skilled in the art will understand that certain features of these embodiments can be combined and other variants will readily occur to those skilled in the art. For example, while particular examples based on PCM devices have been described, it will be apparent to those skilled in the art that the principles described herein could be applied to other resistive switching memories that exhibit drift.

## Claims

1. A neuron circuit of a spiking neural network comprising:
- a first resistive switching memory device (902, 904) having a conductance that decays over time; and
- a programming circuit (1302, 1304) configured to reset the resistive state of the first resistive switching element in response to a spike in an output voltage (POST, PRE) of the neuron circuit.

2. The neuron circuit of claim 1, wherein the first resistive switching memory device (902, 904) is a phase change memory device or a conductive-bridging random-access memory device.

3. The neuron circuit of claim 1 or 2, wherein the neuron circuit is a pre-synaptic neuron circuit (PRE_1 to PRE_7).

4. A spiking neural network comprising:
- the neuron circuit of claim 3; and
- a synapse circuit (402) coupling the neuron circuit to a post synaptic neuron circuit (POST_1 to POST_7), wherein the synapse circuit comprises a further resistive memory device (1322) configured to store a synaptic weight (g_SYNAPSE), wherein the programming circuit, or a further programming circuit (1320), is configured to update the synaptic weight based on a conductance value (g_PRE) of the first resistive switching memory device.

5. The spiking neural network of claim 4, further comprising a control circuit (1306, 1308, 1310, 1316, 1318) configured to read the conductance value (g_PRE) of the first resistive switching memory device (902), to compare the conductance value with a first threshold (g_TH1), and to update the synaptic weight by increasing the conductance of the further resistive memory device if the conductance value exceeds the first threshold.

6. The spiking neural network of claim 5, wherein, in the case that the conductance value does not exceed the first threshold (g_TH1), the control circuit (1306, 1308, 1310, 1316, 1318) is further configured to compare the conductance value with a second threshold (g_TH2), and to update the synaptic weight (g_SYNAPSE) by decreasing the conductance of the further resistive memory device (1322) if the conductance value exceeds the second threshold.

7. The spiking neural circuit of claim 5 or 6, wherein the post-synaptic neuron circuit comprises:
- a second resistive switching memory device (904) having a conductance that decays over time, wherein the programming circuit, or another programming circuit (1312), is configured to reset the resistive state of the second resistive switching element in response to a spike in an output voltage of the post-synaptic neuron circuit.

8. The spiking neural network of claim 7, wherein the control circuit (1306, 1308, 1310, 1316, 1318) is further configured to read the conductance value (g_POST) of the second resistive switching memory device (904), to compare the conductance value of the second resistive switching memory device with a third threshold (g_TH3), and to update the synaptic weight (g_SYNAPSE) by decreasing the conductance of the further resistive memory device (1322) if the conductance value exceeds the third threshold (g_TH3).

9. A method storing a duration between pre- and post-synaptic neuron spikes in a spiking neural network, the method comprising resetting, by a programming circuit (1302, 1312), the resistive state of a first resistive switching element (902, 904) of a neuron circuit in response to a spike in an output voltage of the neuron circuit.

10. A learning method for a spiking neural network, the method comprising:
- storing the duration between pre- and post-synaptic neuron spikes according to the method of claim 9; and
- storing, by the programming circuit (1302, 1304) or by another programming circuit (1320), a synaptic weight (g_SYNAPSE) to a further resistive memory device (1322) of a synapse circuit (402) coupling the neuron circuit to a post synaptic neuron circuit; and
- updating the synaptic weight based on a conductance value (g_PRE) of the first resistive switching memory device.

11. The method of claim 10, further comprising:
- reading, by a control circuit (1306, 1308, 1310, 1316, 1318), the conductance value of the first resistive switching memory device (902);
- comparing the conductance value (g_PRE) with a first threshold (g_TH1); and
- updating the synaptic weight (g_SYNAPSE) by increasing the conductance of the further resistive memory device (1322) if the conductance value exceeds the first threshold.

12. The method of claim 11, further comprising, in the case that the conductance value does not exceed the first threshold (g_TH1):
- comparing the conductance value (g_PRE) with a second threshold (g_TH2); and
- updating the synaptic weight (g_SYNAPSE) by decreasing the conductance of the further resistive memory device if the conductance value exceeds the second threshold.

13. The method of claim 11 or 12, further comprising:
- resetting the resistive state of a second resistive switching memory device (904) of the post-synaptic neuron circuit in response to a spike in an output voltage of the post-synaptic neuron circuit, wherein the second resistive switching memory device (904) has a conductance that decays over time.

14. The method of claim 13, further comprising:
- reading, by the control circuit (1306, 1308, 1310, 1316, 1318), the conductance value of the second resistive switching memory device (904);
- comparing the conductance value (g_POST) of the second resistive switching memory device with a third threshold (g_TH3); and
- updating the synaptic weight (g_SYNAPSE) by decreasing the conductance of the further resistive memory device if the conductance value exceeds the third threshold (g_TH3).

## Amended claims

### Amended claims in accordance with Rule 137(2) EPC.

1. A spiking neural network comprising:
- a pre-synaptic neuron circuit (PRE_1 to PRE_7) comprising a first resistive switching memory device (902) having a conductance that decays over time;
- a post-synaptic neuron circuit (POST_1 to POST_7) comprising a second resistive switching memory device (904) having a conductance that decays over time; and
- one or more programming circuits (1302, 1312) configured to reset the resistive state of the first resistive switching element in response to a spike in an output voltage (PRE) of the pre-synaptic neuron circuit and to reset the resistive state of the second resistive switching element in response to a spike in an output voltage of the post-synaptic neuron circuit; and
- a synapse circuit (402) coupling the pre-synaptic neuron circuit (PRE_1 to PRE_7) to the post-synaptic neuron circuit (POST_1 to POST_7), wherein the synapse circuit comprises a further resistive memory device (1322) configured to store a synaptic weight (g_SYNAPSE), wherein the one or more programming circuits (1302, 1312), or a further programming circuit (1320), is configured to update the synaptic weight in response to a spike in the output voltage of the post-synaptic neuron circuit based on a conductance value (g_PRE) of the first resistive switching memory device and to update the synaptic weight in response to a spike in the output voltage of the pre-synaptic neuron circuit based on a conductance value (g_POST) of the second resistive switching memory device.

2. The spiking neural network of claim 1, wherein the first resistive switching memory device (902, 904) is a phase change memory device or a conductive-bridging random-access memory device.

3. The spiking neural network of claim 1 or 2, further comprising a control circuit (1306, 1308, 1310, 1316, 1318) configured, in response to a spike in the output voltage of the post-synaptic neuron circuit, to read the conductance value (g_PRE) of the first resistive switching memory device (902), to compare the conductance value with a first threshold (g_TH1), and to update the synaptic weight by increasing the conductance of the further resistive memory device if the conductance value exceeds the first threshold.

4. The spiking neural network of claim 3, wherein, in the case that the conductance value does not exceed the first threshold (g_TH1), the control circuit (1306, 1308, 1310, 1316, 1318) is further configured to compare the conductance value with a second threshold (g_TH2), and to update the synaptic weight (g_SYNAPSE) by decreasing the conductance of the further resistive memory device (1322) if the conductance value exceeds the second threshold.

5. The spiking neural network of claim 3 or 4, wherein the control circuit (1306, 1308, 1310, 1316, 1318) is further configured, in response to a spike in the output voltage of the pre-synaptic neuron circuit, to read the conductance value (g_POST) of the second resistive switching memory device (904), to compare the conductance value of the second resistive switching memory device with a third threshold (g_TH3), and to update the synaptic weight (g_SYNAPSE) by decreasing the conductance of the further resistive memory device (1322) if the conductance value exceeds the third threshold (g_TH3).

6. A learning method for a spiking neural network, the method comprising:
- resetting, by one or more programming circuits (1302, 1312): the resistive state of a first resistive switching element (902) of a pre-synaptic neuron circuit (PRE_1 to PRE_7) in response to a spike in an output voltage of the pre-synaptic neuron circuit; and the resistive state of a second resistive switching element (904) of a post-synaptic neuron circuit (POST -1 to POST_7) in response to a spike in an output voltage of the post-synaptic neuron circuit; and
- storing, by the one or more programming circuits (1302, 1312) or by another programming circuit (1320), a synaptic weight (g_SYNAPSE) to a further resistive memory device (1322) of a synapse circuit (402) coupling the pre-synaptic neuron circuit to the post synaptic neuron circuit; and
- updating the synaptic weight in response to a spike in the output voltage of the post-synaptic neuron circuit based on a conductance value (g_PRE) of the first resistive switching memory device and updating the synaptic weight in response to a spike in the output voltage of the pre-synaptic neuron circuit based on a conductance value (g_POST) of the second resistive switching memory device.

7. The method of claim 6, further comprising, in response to a spike in the output voltage of the post-synaptic neuron circuit:
- reading, by a control circuit (1306, 1308, 1310, 1316, 1318), the conductance value of the first resistive switching memory device (902);
- comparing the conductance value (g_PRE) with a first threshold (g_TH1); and
- updating the synaptic weight (g_SYNAPSE) by increasing the conductance of the further resistive memory device (1322) if the conductance value exceeds the first threshold.

8. The method of claim 7, further comprising, in the case that the conductance value does not exceed the first threshold (g_TH1) :
- comparing the conductance value (g_PRE) with a second threshold (g_TH2); and
- updating the synaptic weight (g_SYNAPSE) by decreasing the conductance of the further resistive memory device if the conductance value exceeds the second threshold.

9. The method of claim 7 or 8, further comprising, in response to a spike in the output voltage of the pre-synaptic neuron circuit:
- reading, by the control circuit (1306, 1308, 1310, 1316, 1318), the conductance value of the second resistive switching memory device (904);
- comparing the conductance value (g_POST) of the second resistive switching memory device with a third threshold (g_TH3); and
- updating the synaptic weight (g_SYNAPSE) by decreasing the conductance of the further resistive memory device if the conductance value exceeds the third threshold (g_TH3).
